# EUROPÄISCHE PATENTSCHRIFT

(11) **EP 1 851 390 B1**
(45) Veröffentlichungstag und Bekanntmachung des Hinweises auf die Patenterteilung: **10.10.2012**
(21) Anmeldenummer: 06706883.3
(22) Anmeldetag: 11.02.2006
(51) Int. Cl.: E03C 1/05, H03K 17/96, G05D 23/12

(54) **VORRICHTUNG ZUR BETÄTIGUNG EINER SANITÄRARMATUR**
DEVICE FOR ACTUATING A SANITARY APPLIANCES
DISPOSITIF POUR ACTIONNER UN APPAREIL SANITAIRE

(30) Priorität: 21.02.2005 DE 102005007887
(43) Veröffentlichungstag der Anmeldung: 07.11.2007
(73) Patentinhaber: HANSA METALLWERKE AG, 70567 Stuttgart (DE)
(72) Erfinder: KUNKEL, Horst, 70567 Stuttgart (DE)
(74) Vertreter: Ostertag, Ulrich
(86) Internationale Anmeldenummer: PCT/EP2006/001271
(87) Internationale Veröffentlichungsnummer: WO 2006/087154

(56) Entgegenhaltungen:
- GB-A- 2 263 812
- US-A- 4 339 011
- US-A- 4 805 739
- US-A- 6 003 390
- US-B1- 6 340 936

## Beschreibung

Die Erfindung betrifft eine Vorrichtung zur Betätigung einer Sanitärarmatur nach dem Oberbegriff des Patentanspruchs 1.

Derartige Vorrichtungen sind in Form von Schaltern bekannt, bei denen als druckempfindliches Element des Sensors häufig ein piezoelektrisches Element zum Einsatz kommt.

Der empfindliche Bereich eines solchen Sensors, also der Bereich, auf den ein Benutzer üblicherweise mit seinem Finger einen Druck ausüben muß, damit die Steuereinrichtung eine Betätigung der Sanitärarmatur veranlaßt, ist meist räumlich relativ wenig ausgedehnt. Er ist normalerweise mit einer elastischen Abdeckung versehen, die im wesentlichen der Größe des empfindlichen Bereichs des Sensors entspricht. Ein Benutzer der Sanitärarmatur muß darauf achten, dass dieser empfindliche Bereich möglichst genau mit dem Finger getroffen wird.

Trifft der Benutzer den empfindlichen Bereich des Sensors nämlich nicht hinreichend genau, sondern drückt auf eine von dem empfindlichen Bereich des Sensors beabstandete Stelle, so kann es vorkommen, dass in den Augen des Benutzer der Schalter zwar betätigt wurde, eine entsprechende Steuerung der Sanitärarmatur jedoch ausbleibt, da der Druck nicht auf den empfindlichen Bereich des Sensors wirkt und letzterer nicht anspricht. Zudem sind zur Auslösung eines solchen Sensors vergleichsweise große Kräfte nötig. Insgesamte kann es also zu Unbequemlichkeiten für den Benutzer der Sanitärarmatur kommen.

Auch sind derartige Schalter auf Grund der vorgegebenen Geometrie des Sensors bei Designarmaturen nur eingeschränkt verwendbar, da eine Anpassung des Schalterdesigns an das Design der Armatur schwierig ist.

Eine Vorrichtung der eingangs genannten Art ist aus der US 6 340 936 B1 bekannt geworden. Die dort beschriebene Vorrichtung zur Fußgängerampel-Steuerung wäre im Prinzip auch für die Betätigung einer Sanitärarmatur geeignet. Allerdings weist diese bekannte Vorrichtung nur ein relativ kleines Betätigungsfeld auf, was bei Designerarmaturen unerwünscht sein kann. Eine Vergrößerung des Betätigungsfeldes würde aber zu den oben beschriebenen Problemen führen.

Ähnliches gilt auch für einen aus der US 4 805 739 bekannten Anforderungstaster einer Aufzugsteuerung.

Weitere Betätigungseinrichtungen, die bei Sanitärarmaturen verwendet werden könnten, gehen aus der US 6 003 390, der GB 2 263 812 A und der US 4 339 011 hervor.

Aufgabe der Erfindung ist es, eine Vorrichtung zur Betätigung einer Sanitärarmatur der eingangs genannten Art zu schaffen, welche den oben erläuterten Problemen Rechnung trägt.

Diese Aufgabe wird mit den im Patentanspruch 1 angegebenen Mitteln gelöst.

Wie im Stand der Technik an sich bekannt, ermöglichen es die Koppelmittel, dass der Sensor auch dann anspricht, wenn der Benutzer neben den empfindlichen Bereich des Sensors drückt. Somit ist der Ansprechbereich der Vorrichtung vergrößert und dem Benutzer steht eine größere Druck- oder Schaltfläche zur Verfügung. Dadurch muß er nicht mehr in dem Maße auf eine genaue Fingerführung achten, wie es bei bisherigen Vorrichtungen ähnlicher Art notwendig war. Zudem können die Koppelmittel als sichtbare Komponente vorgesehen sein und in ihrem sichtbaren Bereich an das Design der Sanitärarmatur angepasst werden.

Dabei sind die Koppelmittel so ausgebildet, dass sie eine in Richtung senkrecht zur Betätigungsrichtung des Sensors über den empfindlichen Bereich des Sensors überstehende Abdeckung umfassen, die mittels einer auf ihrer in Richtung auf den Sensor weisenden Innenfläche angeordneten Erhebung mit dem empfindlichen Bereich des Sensors zusammenarbeitet. Durch eine solche Abdeckung wird die Erhebung auch dann gegen den empfindlichen Bereich des Sensors gedrückt, wenn der Benutzer der Sanitärarmatur neben dem empfindlichen Bereich des Sensors auf die Abdeckung drückt.

Wie weiter im Stand der Technik bekannt ist, wird der Sensor von einer Halterung getragen, die an dem Gehäuse fixiert ist.

Derartige Vorrichtungen sind in Form von Schaltern bekannt, bei denen als druckempfindliches Element des Sensors häufig ein piezoelektisches Element zum Einsatz kommt.

Erfindungsgemäß ist an der Innenfläche der Abdeckung eine Tragstruktur vorgesehen, durch welche die Halterung mit der Abdeckung verbunden ist. Die Abdeckung ist somit zumindest mittelbar mit dem Sensor verbunden, wodurch deren Relativpositionen zueinander festgelegt und ein Zusammenarbeiten der beiden Komponenten sicher gewährleistet ist.

Dabei umfasst die Vorrichtung zwei Sensoren, wobei die Tragstruktur durch wenigstens einen im wesentlichen geradlinigen Haltesteg ausgebildet ist, welcher sich entlang einer für die Anordnung der Sensoren geltenden Spiegelebene zwischen den Sensoren erstreckt. Auf diese Weise wird auf einfache Art ein Wippenschalter gebildet. Die Betätigung der Sanitärarmatur kann dadurch über die gesamte Ausdehnung der Vorrichtung längs des Haltestegs erfolgen. Außerdem sind dadurch im Prinzip zwei Funktionen der Sanitärarmatur auslösbar.

Es ist aus technischer Sicht vorteilhaft, wenn das druckempfindliche Element ein piezoelektrisches oder ein piezoresistives Element ist. Ein piezoelektrisches Element erzeugt unter Druckbelastung bekanntermaßen eine Spannung, wogegen ein piezoresistives Element unter Druckbelastung seinen elektrischen Widerstand ändert. Beide Parameter können von einer an sich bekannten und entsprechend ausgestalteten Steuereinrichtung erkannt und einer Deformation des druckempfindlichen Elements und damit dem Ansprechen des zugehörigen Sensors zugeordnet werden.

Dabei ergibt sich ein besseres Druckgefühl für den Benutzer der Sanitärarmatur, wenn die Abdeckung zumindest teilweise elastisch ist.

Nachstehend wird ein Ausführungsbeispiel der erfindungsgemäßen Vorrichtung unter Bezugnahme auf die Zeichnung erläutert. Darin zeigen:
- Figur 1: einen Schnitt eines nicht durch den Anspruch 1 gedeckten Ausführungsbeispiels einer Vorrichtung zur Betätigung einer Sanitärarmatur entlang der Schnittlinie I-I in Figur 2;
- Figur 2: in kleinerem Maßstab einen Schnitt des Ausführungsbeispiels nach Figur 1 entlang der dortigen Schnittlinie II-II;
- Figur 3: einen Schnitt des erfindungsgemäßen Ausführungsbeispiels einer Vorrichtung zur Betätigung einer Sanitärarmatur entlang der Schnittlinie III-III in Figur 4;
- Figur 4: in kleinerem Maßstab einen Schnitt des Ausführungsbeispiels nach Figur 3 entlang der dortigen Schnittlinie IV-IV;
- Figur 5: einen Schnitt eines weiteren nicht durch den Anspruch 1 gedeckten Ausführungsbeispiels einer Vorrichtung zur Betätigung einer Sanitärarmatur entlang der Schnittlinie V-V in Figur 6; und
- Figur 6: in kleinerem Maßstab einen Schnitt des Ausführungsbeispiels nach Figur 5 entlang der dortigen Schnittlinie VI-VI.

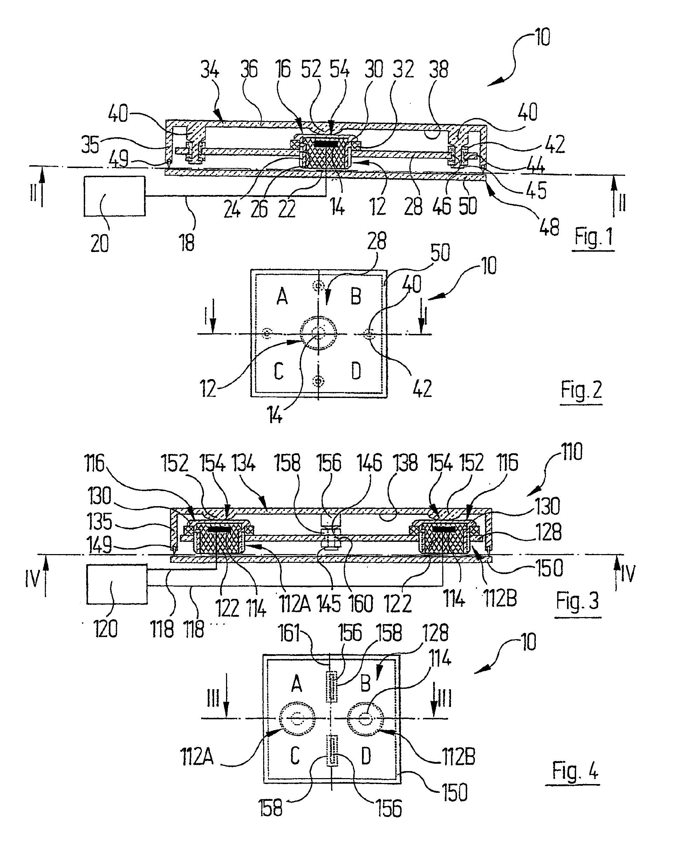

Figur 1 zeigt illustrativ ein erstes, nicht durch den Patentanspruch 1 gedecktes Beispiel einer Vorrichtung zur Betätigung einer Sanitärarmatur, welche als Einfach-Schalter 10 ausgebildet ist. Der Schalter 10 umfasst einen Sensor 12 mit einem druckempfindlichen Element 14, welches in ein von einer überwiegend elastischen Hülle 16 umgebenes, ebenfalls elastisches Schutzmaterial 22 eingelassen ist. Bei dem druckempfindlichen Element 14 handelt es sich um ein piezoelektrisches Element 14, wie es an sich bekannt ist. Alternativ kann ein piezoresistives Element eingesetzt werden.

Wird auf das piezoelektrische Element 14 des Sensors 12 ein Druck in Figur 1 von oben ausgeübt, so wird die dadurch erzeugte elektrische Spannung über eine Leitung 18 von einer Steuereinrichtung 20 erfasst. Die Steuereinrichtung 20 steuert daraufhin in bekannter Weise eine dem Schalter 10 zugeordnete Funktion der (nicht dargestellten) Sanitärarmatur. Bei dieser Funktion kann es sich um alle üblichen Funktionen einer Sanitärarmatur handeln. Beispielhaft seien die Wassertemperatur und der Volumenstrom des austretenden Wasserstrahls genannt.

Das das piezoelektrische Element 14 umgebende Material 22 gibt einen darauf ausgeübten Druck auf das piezoelektrische Element 14 weiter. Die Hülle 16 weist in ihrer Mantelfläche einen unelastischen Bereich auf, in den ein Gewinde 24 eingeschnitten ist. Über dieses ist der Sensor 12 in eine komplementäre Gewindeöffnung 26 eingeschraubt, welche mittig in einer quadratischen Halteplatte 28 vorgesehen ist.

Die Hülle 16 des Sensors 12 weist an ihrem dem Gewinde 24 gegenüberliegenden Ende einen umlaufenden Kragen 30 auf, mit dem der Sensor 12 auf einen zwischen seinem Kragen 30 und der Halteplatte 28 angeordneten Dämpfungsring 32 aufliegt, wenn er in die Halteplatte 28 eingeschraubt ist.

Die Halteplatte 28 wird von einer haubenförmigen elastischen Abdeckung 34 getragen, die über dem Sensor 12 vorgesehen ist. Die Abdeckung 34 umfaßt eine quadratische Druckplatte 36, welche sich zu allen Seiten ein wenig über die Abmessung der Halteplatte 28 hinaus erstreckt.

Zur Befestigung der Halteplatte 28 sind an der Innenfläche 38 der Druckplatte 36 vier Haltestifte 40 mit kreisförmigem Querschnitt angeformt, welche jeweils mittig in den äußeren Randbereichen der Druckplatte 36 der Abdeckung 34 angeordnet sind, wie insbesondere in Figur 2 zu erkennen ist.

Die Haltestifte 40 haben an ihrem die Halteplatte 28 tragenden Endbereich einen verjüngten Abschnitt, auf den ein elastischer Haltering 42 mit einer umlaufenden Außennut 44 aufgeschoben ist. Ein Kragen 45 am Ende des Haltestifts 40 verhindert, daß der elastische Haltering 42 von dem Haltestift 40 herunterrutscht.

Die Halteplatte 28 weist vier Öffnungen 46 auf, deren Anordnung der Anordnung der Haltestifte 40 entspricht und die zu den Außennuten 44 der Halteringe 42 komplementär sind. Über diese Öffnungen 46 ist die Halteplatte 28 auf die Haltestifte 40 aufgeschoben und liegt in den Außennuten 44 der Halteringe 42.

Die Abdeckung 34 hat insgesamt die Form einer Haube mit quadratischem Deckel, der durch die Druckplatte 36 gebildet ist. Die Abdeckung 34 ist als Teil eines Gehäuses 48 mit dem Rand ihrer Umfangswand 35 über eine elastische Dichtlippe 49 mit dem Boden 50 des Gehäuses 48 verbunden.

Die Abmessungen der einzelnen Komponenten sind derart aufeinander abgestimmt, daß bei unbetätigtem Schalter 10 ein Abstand zwischen dem Sensor 12 und dem Boden 50 des Gehäuses 48 verbleibt.

Die Druckplatte 36 der Abdeckung 34 weist zentriert auf ihrer Innenseite 38 eine unelastische gewölbte Erhebung 52 auf, welche den empfindlichen Bereich 54 des Sensors 12 berührt. Unter dem empfindlichen Bereich 54 des Sensors 12 ist derjenige Bereich zu verstehen, auf den ein bestimmter Druck ausgeübt werden muß, damit das piezoelektrische Element 14 eine Spannung erzeugt.

Wie in den Figuren 1 und 2 zu erkennen ist, ist die seitliche Erstreckung des Schalters 10 und damit auch der Abdeckung 34 insgesamt deutlich größer als diejenige des Sensors 12 und des darin angeordneten piezoelektrischen Elements 14.

Die oben beschriebene Ausgestaltung des Schalters 10 ermöglicht es, daß im wesentlichen die gesamte sichtbare Außenfläche der Druckplatte 36 der Abdeckung 34 als Druckfläche für einen Benutzer zur Verfügung steht, welcher die Sanitärarmatur gebrauchen möchte. Es ist nicht nötig, daß der Druck durch beispielsweise den Finger des Benutzers lokal auf den oder zumindest in großer Nähe zu dem empfindlichen Bereich 54 des Sensors 12 erfolgt. Durch die gewölbte Erhebung 52 der Abdeckung 34 ist gewährleistet, daß auch ein im Abstand von dem empfindlichen Bereich 54 des Sensors 12 auf die Druckplatte 36 der Abdeckung 34 ausgeübter Druck auf den empfindlichen Bereich 54 des Sensors 12 und so auf das piezoelektrische Element 14 übertragen wird.

Zur Veranschaulichung sei der Schalter 10 bzw. die Druckplatte 36 der Abdeckung 34 in vier gleich große quadratische Bereiche A, B, C und D unterteilt, wie es in Figur 2 dargestellt ist. Es sei darauf hingewiesen, daß sich die Druckfläche der Abdeckung 34 bei der in Figur 2 gezeigten Ansicht des Schalters 10 hinter der Papierebene auf der dem Betrachter entgegengesetzten Seite befindet.

Wird nun beispielsweise die Abdeckung 34 im Bereich A (vgl. Figur 2) eingedrückt, so gibt die elastische Druckplatte 36 an der Druckstelle nach innen nach. Die Halteplatte 28 wird mittels der Haltestifte 40 solange in Richtung auf den Boden 50 des Gehäuses 48 mitgeführt, bis der darin eingeschraubte Sensor 12 gegen den Boden 50 anstößt. Bei weiterem Niederdrücken der Druckplatte 36 bewegt sich die unelastische Erhebung 52 der Abdeckung 34 weiter nach innen, wodurch ein Druck auf den empfindlichen Bereich 54 des Sensors 12 ausgeübt wird, der sich nun nicht weiter in Richtung auf den Boden 50 des Gehäuses 48 bewegen kann. Dieser Druck reicht aus, um das piezoelektrische Element 14 zu aktivieren, was die gewünschte Steuerung der Sanitärarmatur zur Folge hat.

Die Abdeckung 34 und deren nach innen weisende gewölbte Erhebung 52 bilden somit Koppelmittel, durch welche eine im Abstand von dem empfindlichen Bereich 54 des Sensors 12 ausgeübte Kraft auf den empfindlichen Bereich 54 des Sensors 12 übertragen wird.

Durch die Ausbildung des Schalters 10 wird in gewissem Umfang auch eine Druckverstärkung erreicht; ein großflächig auf die Druckplatte 36 ausgeübter Druck wird verstärkt auf den kleinflächigen empfindlichen Bereich 54 des Sensors 12 übertragen.

Die Figuren 3 und 4 zeigen das erfindungsgemäße Ausführungsbeispiel einer Vorrichtung zur Betätigung einer Sanitärarmatur, wobei dem ersten Ausführungsbeispiel entsprechende Komponenten mit denselben Bezugszeichen zuzüglich 100 gekennzeichnet sind.

Wie in den Figuren 3 und 4 zu erkennen ist, umfasst der dort dargestellte Zweifach-Schalter 110 zwei Sensoren 112A und 112B, die beide über jeweils eine Leitung 118 mit der Steuereinrichtung 120 verbunden sind. Die Sensoren 112 sind symmetrisch zum Mittelpunkt auf einer durch den Mittelpunkt der Halteplatte 128 verlaufenden und senkrecht auf zwei gegenüberliegenden Seitenrändern der Halteplatte 128 stehenden Geraden auf der Halteplatte 128 angeordnet.

Im Gegensatz zu dem ersten Ausführungsbeispiel sind bei dem Ausführungsbeispiel der Figuren 3 und 4 auf der Innenseite 138 der Abdeckung 134 keine Haltestifte 40 mit kreisförmigem Querschnitt angeformt, sondern zwei langgestreckte Haltestege 156, die in einem verjüngten Bereich entsprechend langgestreckt ausgebildete elastische Halteringe 158 mit einer umlaufenden Außennut 160 tragen. In dieser sitzt die Halteplatte 128 über komplementär ausgebildete Öffnungen 146 ein.

Die Haltestege 156 erstrecken sich entlang einer für die Anordnung der Sensoren 112A und 112B geltenden Spiegelebene 161, die in Figur 4 als gestrichelte Linie angedeutet ist. Ein Haltesteg 156 liegt dabei auf der Grenzlinie zwischen den zum ersten Ausführungsbeispiel bereits genannten Bereichen A und C und der andere Haltesteg 156, symmetrisch zur Schnitt- und Symmetrieebene III-III der Figur 4, auf der Grenzlinie zwischen den entsprechenden Bereichen B und D des Schalters 110. Dies ist in Figur 4 zu erkennen.

Dieser Schalter 110 eignet sich als Zwei-Funktionen-Taster oder Ein/Aus-Schalter. Wird nämlich die Druckplatte 136 der Abdeckung 134 entweder im Bereich A oder C niedergedrückt, so wird lediglich der in den Figuren 3 und 4 links liegende Sensor 112A aktiviert. Die Stege 156 wirken als Wippenlager und verhindern eine Kraftübertragung auf den empfindlichen Bereich 154 des in den Figuren 3 und 4 rechts liegenden Sensors 112B.

Während sich die Erhebung 152 über dem Sensor 112A auf diesen zu bewegt, wird die Erhebung 152 über dem Sensor 112B von dem Sensor 112B abgehoben.

Wird die Druckplatte 136 der Abdeckung 134 dagegen in einem der Bereiche B oder D niedergedrückt, so wird dadurch lediglich der Sensor 112B aktiviert.

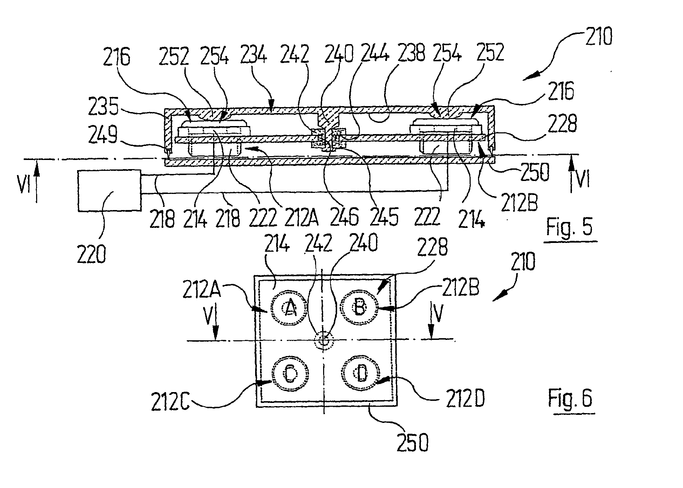

In den Figuren 5 und 6 ist ein weiteres, ebenfalls durch den Patentanspruch 1 nicht gedecktes Ausführungsbeispiel einer Vorrichtung zur Betätigung einer Sanitärarmatur gezeigt, wobei dem Ausführungsbeispiel der Figuren 1 und 2 entsprechende Komponenten mit denselben Bezugszeichen zuzüglich 200 gekennzeichnet sind.

Wie in den Figuren 5 und 6 zu erkennen ist, umfasst der dortige Vierfach-Schalter 210 vier Sensoren 212A, 212B, 212C und 212D. Diese sind jeweils mittig unter einem Bereich A, B, C und D der Druckplatte 236 der Abdeckung 234 auf der Halteplatte 228 angeordnet, und zwar jeweils unter einer an die Innenseite 238 der Druckplatte 236 angeformten Erhebung 252.

Zur Befestigung der Abdeckung 234 an der Halteplatte 228 ist hier lediglich ein einziger Haltestift 240 am Mittelpunkt der Innenseite 238 der Druckplatte 236 angeformt. Um eine sichere Befestigung der Halteplatte 228 an der Abdeckung 234 zu gewährleisten, weist der elastische Haltering 242 eine größere radiale Erstreckung auf und seine Außennut 244 ist tiefer ausgebildet als bei dem Haltering 40 des ersten Ausführungsbeispiels.

Wird nun die Druckplatte 36 der Abdeckung 34 in einem der Bereiche A, B, C oder D niedergedrückt, so wird lediglich der sich unterhalb des entsprechenden Bereichs A, B, C oder D der Druckplatte 236 befindliche Sensor 212A, 212B, 212C bzw. 212D aktiviert, worauf die Sanitärarmatur entsprechend der dem aktivierten Sensor 212 zugeordneten Funktion gesteuert wird.

Bei einer Abwandlung der oben beschriebenen Ausführungsbeispiele ist die Abdeckung 34, 134 bzw. 234 aus starrem Material gefertigt. Dabei ist durch das Nachgeben der elastischen Dichtlippe 49, 149 bzw. 249 gewährleistet, dass die Halteplatte 28, 128 bzw. 228 wie oben beschrieben in Richtung auf den Boden 50, 150, 250 des Gehäuses 48, 148 bzw. 248 bewegt werden kann, bis der Sensor 12, 112 bzw. 212 den Boden 50, 150 bzw. 150 berührt.

Es sei betont, daß im Falle einer starren Abdeckung 34, 134 bzw. 234 die Abmessungen der einzelnen Komponenten des Schalters 10, 110 bzw. 210 derart aufeinander abgestimmt sind, daß der bei unbetätigtem Schalter 10, 110 bzw. 210 zwischen dem Sensor 12, 112 bzw. 212 und dem Boden 50, 150 bzw. 150 des Gehäuses 48, 148 bzw. 248 verbleibende Abstand geringer ist als der von der Dichtlippe 49, 149 bzw. 249 eingenommene Bereich zwischen dem Rand der Umfangswand 35, 135 bzw. 235 der Abdeckung 34, 134 bzw. 234 und dem Boden 50, 150 bzw. 150 des Gehäuses 48, 148 bzw. 248.

Die oben beschriebenen Schalter 10, 110 und 210 erlauben eine bequemere Bedienung von Sanitärarmaturen, welche Sensoren verwenden, auf die zum Betätigen der Sanitärarmatur in einem empfindlichen Bereich eine Kraft ausgeübt werden muß. Beim Drücken des Schalters 10, 110 oder 210 muß nicht mehr darauf geachtet werden, daß der empfindliche Bereich 54, 154, 254 des Sensors 12, 112 bzw. 212 möglichst genau getroffen wird, indem die Abdeckung 34, 134 bzw. 234 möglichst genau oberhalb des Sensors 12, 112, 212 eingedrückt wird. Auch ein "ungenaues" Drücken in einer gewissen Entfernung von dem empfindlichen Bereich 54, 154, 254 des Sensors 12, 112, 212, die je nach Ausbildung des Schalters 10, 110, 210 bis zum Mehrfachen der Ausdehnung des empfindlichen Bereichs 54, 154, 254 des Sensors 12, 112, 212 betragen kann, führt zu dem gewünschten Betätigen der Sanitärarmatur.

Darüberhinaus ist durch eine entsprechende Ausgestaltung der zugehörigen Abdeckungen 34, 134 bzw. 234 der Schalter 10, 110 und 210 eine Anpassung an das Design einer bestimmten Sanitärarmatur ohne großen Aufwand möglich.

## Patentansprüche

1. Vorrichtung zur Betätigung einer Sanitärarmatur, welche umfasst:
a) ein Gehäuse;
b) wenigstens einen in dem Gehäuse angeordneten Sensor (112A, 112B) mit einem druckempfindlichen Element (114), wobei zum Betätigen der Sanitärarmatur auf einen empfindlichen Bereich (154) des Sensors (112A, 112B) eine Kraft ausübbar ist, durch die das Element (114) deformiert wird; und
c) eine Steuereinrichtung (120), welche die Deformation des Elements (114) erfasst und hierauf ein Signal erzeugt, durch welches eine Funktion der Sanitärarmatur steuerbar ist,
wobei
d) Koppelmittel (134, 152) vorgesehen sind, welche sich in Richtung senkrecht zur Betätigungsrichtung des Sensors (112A, 112B) über den empfindlichen Bereich (154) des Sensors (112A, 112B) hinaus erstrecken und durch welche eine im Abstand von dem empfindlichen Bereich (154) des Sensors (112A, 112B) ausgeübte Kraft auf den empfindlichen Bereich (154) des Sensors (112A, 112B) übertragbar ist,
e) die Koppelmittel (134, 152) eine in Richtung senkrecht zur Betätigungsrichtung des Sensors (112A, 112B) über den empfindlichen Bereich (154) des Sensors (112A, 112B) überstehende Abdeckung (134) umfassen, die mittels einer auf ihrer in Richtung auf den Sensor (112A, 112B) weisenden Innenfläche (138) angeordneten Erhebung (152) mit dem empfindlichen Bereich (154) des Sensors (112A, 112B) zusammenarbeitet,
f) der Sensor (112A, 112B) von einer Halterung (128) getragen ist, die an dem Gehäuse fixiert ist,
**dadurch gekennzeichnet, dass**
g) eine Tragstruktur an der in Richtung auf den Sensor (112A, 112B) weisenden Innenfläche (138) der Abdeckung (134) vorgesehen ist, durch welche die Halterung (128) mit der Abdeckung (134) verbunden ist,
h) die Vorrichtung zwei Sensoren (112A, 112B) umfasst, wobei die Tragstruktur durch wenigstens einen im wesentlichen geradlinigen Haltesteg (156) ausgebildet ist, welcher sich entlang einer für die Anordnung der Sensoren (112A, 112B) geltenden Spiegelebene zwischen den Sensoren (112A, 112B) erstreckt.

2. Vorrichtung nach Anspruch 1, **dadurch gekennzeichnet, dass** das Element (114) ein piezoelektrisches oder ein piezoresistives Element (114) ist.

3. Vorrichtung nach Anspruch 1 oder 2, **dadurch gekennzeichnet, dass** die Abdeckung (134) zumindest teilweise elastisch ist.

## Claims

1. Device for actuating a sanitary appliance, the device comprising:
a) a housing;
b) at least one sensor (112A, 112B) arranged in the housing and provided with a pressure-sensitive element (114), wherein, for the purpose of actuating the sanitary appliance, a force that causes the element (14) to be deformed can be applied to a sensitive region (154) of the sensor (112A, 112B); and
c) a control system (120), which measures the deformation of the element (114) and thereupon generates a signal by which a function of the sanitary appliance is controllable,
wherein
d) coupling means (134, 152) are provided, which extend, in a direction perpendicular to the direction of actuation of the sensor (112A, 112B), beyond the sensitive region (154) of the sensor (112A, 112B), and which enable a force applied at a distance from the sensitive region (154) of the sensor (112A, 112B) to be transferred to the sensitive region (154) of the sensor (112A, 112B),
e) the coupling means (134, 152) comprise a cover (134) which projects, in a direction perpendicular to the direction of actuation of the sensor (112A, 112B), beyond the sensitive region (154) of the sensor (112A, 112B) and which cooperates with the sensitive region (154) of the sensor (112A, 112B) by means of an elevation (152) arranged on its inner surface (138) that faces towards the sensor (112A, 112B),
f) the sensor (112A, 112B) is carried by a mount (128) which is fixed by the housing,
**characterized in that**
g) a carrying structure that connects the mount (128) to the cover (134) is provided on the inner surface (138) of the cover (134) that faces towards the sensor (112A, 112B),
h) the device comprises two sensors (112A, 112B), the carrying structure being constituted by at least one substantially rectilinear retaining web (156) which extends along a mirror plane of symmetry between the sensors (112A, 112B) that is applicable to the arrangement of the sensors (112A, 112B).

2. Device according to Claim 1, **characterized in that** the element (114) is a piezoelectric or a piezoresistive element (114).

3. Device according to Claim 1 or 2, **characterized in that** the cover (134) is at least partially elastic.

## Revendications

1. Dispositif d'actionnement d'une robinetterie sanitaire, comprenant :
a) un carter ;
b) au moins un capteur (112A, 112B) logé dans ledit carter et présentant un élément (114) sensible à la pression, sachant qu'en vue d'actionner la robinetterie sanitaire, une zone sensible (154) dudit capteur (112A, 112B) peut être soumise à l'action d'une force sous l'effet de laquelle ledit élément (114) est déformé ; et
c) un dispositif de commande (120) qui détecte la déformation dudit élément (114) et génère, sur cette base, un signal par lequel une fonction de ladite robinetterie sanitaire peut être commandée,
sachant
d) qu'il est prévu des moyens de couplage (134, 152) qui s'étendent dans une direction perpendiculaire à la direction d'actionnement du capteur (112A, 112B), au-delà de la zone sensible (154) dudit capteur (112A, 112B), et par lesquels une force, appliquée à distance de ladite zone sensible (154) dudit capteur (112A, 112B), peut être répercutée sur ladite zone sensible (154) dudit capteur (112A, 112B),
e) que lesdits moyens de couplage (134, 152) comportent une coiffe (134) qui dépasse de la zone sensible (154) du capteur (112A, 112B), dans une direction perpendiculaire à la direction d'actionnement dudit capteur (112A, 112B), et qui coopère avec ladite zone sensible (154) dudit capteur (112A, 112B) au moyen d'une protubérance (152) située sur sa face intérieure (138) pointant en direction dudit capteur (112A, 112B), et
f) que ledit capteur (112A, 112B) est supporté par un élément de retenue (128) consigné à demeure sur le carter,
**caractérisé par le fait**
g) **qu'**une structure de support, par l'intermédiaire de laquelle l'élément de retenue (128) est relié à la coiffe (134), est prévue à la face intérieure (138) de ladite coiffe (134) qui pointe en direction du capteur (112A, 112B), et
h) **que** ledit dispositif comprend deux capteurs (112A, 112B), la structure de support étant constituée par au moins une membrure d'arrêt (156) sensiblement rectiligne qui s'étend, entre les capteurs (112A, 112B), le long d'un plan de symétrie assigné à la disposition desdits capteurs (112A, 112B).

2. Dispositif selon la revendication 1, **caractérisé par le fait que** l'élément (114) est un élément (114) piézoélectrique ou piézorésistif.

3. Dispositif selon la revendication 1 ou 2, **caractérisé par le fait que** la coiffe (134) est, au moins partiellement, douée d'élasticité.
